# EUROPEAN PATENT APPLICATION

(11) **EP 3 531 813 A1**
(43) Date of publication of application: **28.08.2019**
(21) Application number: 18158161.2
(22) Date of filing: 22.02.2018
(51) Int. Cl.: H05K 9/00

(54) **METHOD FOR ATTACHING A CABLE TO A METAL STRUCTURE OF AN ELECTRONIC DEVICE TO REDUCE ELECTROMAGNETIC EMISSIONS BY THE CABLE, AND ELECTRONIC DEVICE**

(71) Applicant: Vestel Elektronik Sanayi ve Ticaret A.S., 45030 Manisa (TR)
(72) Inventor: BALLI, Metincan, 45030 Manisa (TR)
(74) Representative: Thomas, Michael Andrew

(57) **Abstract**

A method is provided for maintaining a position of a signal-carrying cable (25) in a position against a metal structure (35), thereby to reduce electromagnetic emissions by the cable (25) when in use. The method comprises: determining that at least a portion of the cable (25) is no longer in said position against the metal structure (35); and, in response thereto, urging a movable member (50) against at least a portion of the cable (25) thereby to urge the at least a portion of the cable (25) against the metal structure (35). One or both of the cable (25) and the metal structure (35) are provided with a re-attachable fixing for attaching at least a portion of the cable (25) in said position against the metal structure (35). Urging the movable member (50) against at least a portion of the cable (25) attaches the at least a portion of the cable (25) by the re-attachable fixing.

## Description

### Technical Field

The present disclosure relates to a method for attaching a cable to a metal structure of an electronic device to reduce electromagnetic emissions by the cable when in use, and to an electronic device.

### Background

A Low Voltage Differential Signalling (LVDS) interface is used in many types of electronic device to transmit data within the device at high data rates. For example, in a television having a liquid crystal display (LCD), an LVDS interface, communicating over an LVDS cable, is used to communicate image data from a main circuit board of the television to an LCD display panel to display images.

It is important that electronic devices satisfy applicable electromagnetic interference standards. In applications such as LCD televisions and other digital display devices, LVDS cables are known to emit a certain amount of electromagnetic interference. Various techniques are known and applied in the design of LCD televisions and other digital display devices to reduce that interference. However, during use of the device, it is possible that a feature that was preventing excessive emission of interference may become displaced or damaged, so reducing its effectiveness.

### Summary

According to a first aspect disclosed herein, there is provided a method for maintaining a position of a signal-carrying cable against a metal structure to reduce electromagnetic emissions by the cable when in use, the method comprising:
determining that at least a portion of the cable is no longer in the position against the metal structure; and,
in response thereto, urging a movable member against at least a portion of the cable thereby to urge the at least a portion of the cable against the metal structure.

By this method, if a portion of the cable becomes detached from the metal structure during use, the cable may be re-attached or repositioned against the metal structure and so reduce electromagnetic emissions from the cable.

In an example, one or both of the cable and the metal structure are provided with a re-attachable fixing for attaching at least a portion of the cable in the position against the metal structure, and the urging the movable member against at least a portion of the cable attaches the at least a portion of the cable in said position against the metal structure by the re-attachable fixing.

Several methods are disclosed for applying pressure to the cable using the movable member.

In an example, the method comprises moving the movable member along the at least a portion of the cable while in contact with the at least a portion of the cable, thereby to urge the at least a portion of the cable against the metal structure.

In an example, the movable member is linked to a motor and the method comprises controlling the motor to move the movable member thereby to urge the at least a portion of the cable against the metal structure.

In an example, the method comprises sensing a change in the configuration of the at least a portion of the cable using a sensor, indicative that a repositioning of the at least a portion of the cable is required, and activating the motor to urge the at least a portion of the cable against the metal structure.

In an example of the method, the sensor comprises one or more of a camera, a movement sensor, a displacement sensor and a receiver of electromagnetic signals, arranged to sense a change in the configuration of the at least a portion of the cable.

In an example, the sensor is a receiver of electromagnetic signals and the method comprises, upon detecting an increase in the emission of electromagnetic signals, activating the motor to urge the at least a portion of the cable against the metal structure.

According to a second aspect disclosed herein, there is provided an electronic device comprising:
a metal structure;
a cable for carrying signals, at least a portion of the cable being in a position against the metal structure to reduce electromagnetic emissions by the cable when in use;
a movable member; and
a sensor arrangement configured to determine when the at least a portion of the cable is no longer in said position against the metal structure,
the arrangement being such that the movable member is urged against at least a portion of the cable in response to the sensor arrangement determining that the at least a portion of the cable is no longer in said position against the metal structure.

In an example of the electronic device, one or both of the at least a portion of the cable and the metal structure are provided with a re-attachable fixing for attaching at least a portion of the cable in said position against the metal structure, and the urging the movable member against at least a portion of the cable attaches the at least a portion of the cable in said position against the metal structure by the re-attachable fixing.

In an example of the electronic device, the movable member is arranged to move along the at least a portion of the cable while in contact with the at least a portion of the cable, thereby to urge the at least a portion of the cable against the metal structure.

In an example of the electronic device, the movable member is mounted to move about a pivot while in contact with the at least a portion of the cable, thereby to urge the at least a portion of the cable against the metal structure.

In an example, the electronic device comprises a motor linked to move the movable member thereby to urge the at least a portion of the cable against the metal structure.

In an example of the electronic device, the sensor arrangement comprises a controller linked to a sensor and to the motor, the sensor comprising at least one of a camera, a movement sensor, a displacement sensor and a receiver of electromagnetic signals, wherein the controller is configured to receive sensor data from the sensor, to detect therefrom a change in the configuration of the at least a portion of the cable, indicative that the at least a portion of the cable is no longer in said position against the metal structure, and to activate the motor to urge the at least a portion of the cable against the metal structure.

In an example of the electronic device, the sensor is a receiver of electromagnetic signals, the controller being configured, upon detecting an increase in the emission of electromagnetic signals, to activate the motor to urge the at least a portion of the cable against the metal structure

### Brief Description of the Drawings

To assist understanding of the present disclosure and to show how embodiments may be put into effect, reference is made by way of example to the accompanying drawing in which:

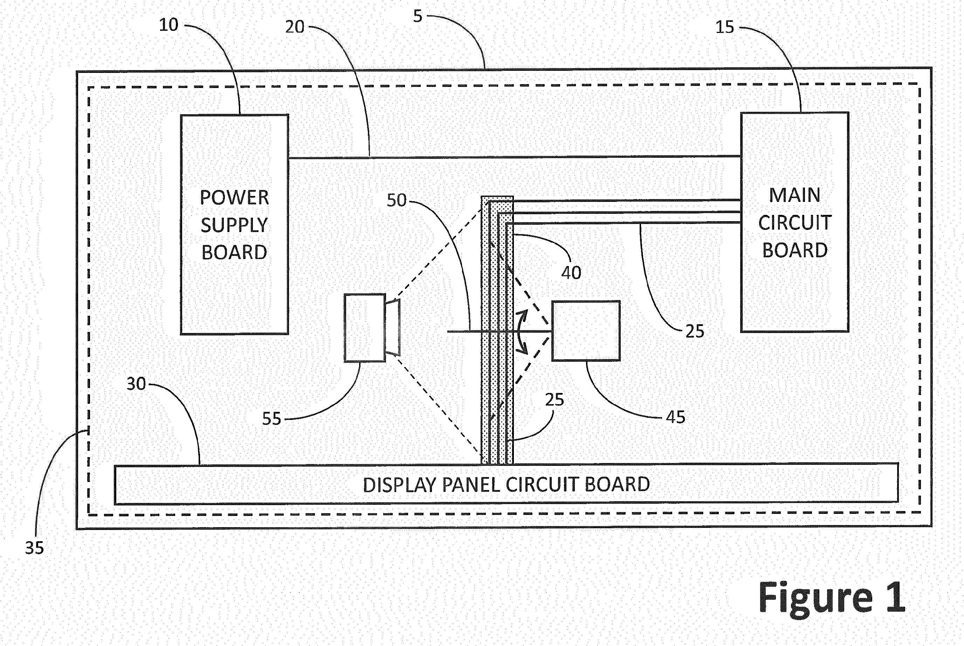

Figure 1 shows schematically example components of a television, being an example of an electronic device disclosed herein.

### Detailed Description

LVDS interfaces and cables are used in many different types of electronic device, including devices that have digital display screens. Various techniques are known to avoid excessive emission of electromagnetic interference from an LVDS cable linking a main circuit board or "mainboard" of the electronic device to the digital display screen. One such technique involves providing a metal layer within the structure of the television, for example a thin metal back-plate, connected to 'ground', to provide some electromagnetic shielding. At least a portion of the LVDS cable may be adhered to or otherwise maintained in a position against the metal back-plate, for example within 0 or 1 to 5mm of the back-plate. In this way, electromagnetic emissions from the LVDS cable are reduced due to the shielding provided by the grounded metal back-plate and due to electromagnetic coupling of the cable and the back-plate where the cable is in a position against the back-plate.

In one example, the LVDS cable may be adhered to the metal back-plate using an adhesive applied to one or both of the back-plate and the LVDS cable. It is beneficial, to enable maintenance, for the cable to be adhered by a re-attachable method rather than permanently attached. To this end, the adhesive may be for example of a type that remains sticky for a long period, ideally for the expected lifetime of the electronic device. In another example, a "hook and loop" fixing system may be used, comprising a fabric (loop) layer attached to one of the cable or the back-plate and a hook layer attached to the other. During manufacture, the LVDS cable may be attached to the back-plate using the selected attachment method in the expectation that the cable will remain attached during the lifetime of the television.

However, it is known that during use of an electronic device, the attachment of the LVDS cable against a back-plate may become undone due to impact or vibration of the device during use. If a part of the cable becomes separated, e.g. by more than 5mm from the back-plate, the electromagnetic coupling of the cable and the back-plate is reduced or eliminated, so increasing the radiation of electromagnetic interference from the cable.

An example technique according to the present disclosure for overcoming the separation of a cable from an associated structure during use of the respective electronic device will now be described with reference to Figure 1 for the particular example of a television having a digital display screen. In the particular example to be described, the technique enables a re-attaching of a cable having with a re-attachable fixing to a metal back-plate connected to 'ground' or 0 volts, as discussed above. The example technique will be described in the particular context of a television or other display device, although it will be apparent that the technique may be applied in other electronic devices in which LVDS cables are used, in particular in electronic devices that have a digital display panel or screen.

Referring to Figure 1, a television 5 is shown schematically to include a power supply board 10, connected to supply power to a main circuit board 15 (often simply called a "mainboard") via a power cable 20. An LVDS cable 25 links the main circuit board 15 to a display panel circuit board 30. A metal back-plate 35 is provided towards a rear of the television structure such that the power supply board 10, main circuit board 15 and display panel circuit board 30 are all located on an interior side of the back-plate 35.

At least a portion of the LVDS cable 25 is attached, during manufacture of the television, to the back-plate 35. This helps to reduce electromagnetic emissions from the cable 25 by electromagnetically coupling the conductors of the cable 25 and the metal of the back-plate 35. The method of attachment of the LVDS cable 25 to the back-plate 35 may comprise applying to an area 40 of the interior surface of the metal back-plate 35 a sticky adhesive compound that is intended to remain sticky for the expected lifetime of the television 5. The portion of the cable 25 may be adhered to the sticky area 40 by pressing the cable 25 against the sticky area 40. Alternatively, or in addition, the sticky adhesive compound may be applied only to the portion of the cable 25 to be adhered, or to both the portion of the cable 25 and to the area 40 of the back-plate 35.

Alternatively, a "hook and loop" re-attachable fixing system may be applied to the area 40 of the back-plate 35 and to the portion of the cable 25 to be attached. Other known attachable and re-attachable fixings may be applied to the area 40 and/or to the portion of the cable 25 to be attached at the area 40 of the back-plate 35, as would be apparent to a person of ordinary skill in the relevant art. These other known fixings may include mechanical fastening arrangements, such as clips and/or screws and the like.

The television 5 is also provided with a motor 45 arranged to move a bar 50 or other movable member into contact with the cable 25 or while in contact with the cable 25. The movable bar 50 or other movable member is arranged, as it moves, to apply a pressure to the cable 25 along a portion of the cable 25 that is intended to be attached to the metal back-plate 35. In one example arrangement, the motor 45 may move the bar 50, when in contact with the cable 25, about a pivot point near to one end of the bar 50, as shown in Figure 1. In this way, the bar 50 applies pressure over respective parts of the cable 25 as it moves, the range of respective parts of the cable 25 being determined according to the range of rotary movement of the bar 50 and the length of the bar 50.

In an alternative example arrangement, the bar 50 may be mounted on a sliding mechanism so that the bar 50 remains in contact with the portion of the cable 25. The motor 45 may be activated to move the mechanism and the bar 50 along that portion of the cable 25 that is intended to remain attached to the back-plate 35, thereby pressing the cable 25 against the back-plate 35, separated from the back-plate 35 only by the fixing, as it moves.

In a further alternative example arrangement, the movable member may comprise a moveable plate that may be moved into contact with the portion of the cable 25 to be attached, thereby pressing the cable 25 into contact with the back-plate 35. In any of these ways, if a re-attachable fixing is used to adhere the cable 25 to the back-plate 35, the fixing may be engaged under pressure from the movable member.

In a further alternative arrangement, the movable member may be moved into contact with the portion of the cable 25 to be attached to the back-plate 35 and remain in position to provide a continuing pressure urging the portion of the cable 25 against the back-plate 35. In this way a fixing may be used that is not easily re-attachable or which may lose its re-attachable property over time. For example, if a fixing is used based upon screws which may become loose or if a fixing is used comprising a sticky adhesive compound that loses it stickiness over time, then re-attachment of the portion of the cable 25 to the back-plate 35 may not be possible by a transient application of pressure by the movable member. A movable member that remains in position is therefore beneficial with such fixings.

To achieve a required reduction in electromagnetic emissions by the cable 25, the portion of cable 25 to be attached to the back-plate 35 need not necessarily be fixed in a position in direct contact against the back-plate 35. For example, the fixing may hold the portion of the cable 25 in a position against the back-plate without the cable 25 necessarily touching the back-plate 35. Application of pressure upon the cable 25 by the movable member may therefore result either in the portion of the cable 25 being urged into contact with the back-plate 35, or being urged to a position against the back-plate separated by the thickness of the fixing, according to the fixing type and the cable and interface standard used. The size of a separation of the portion of the cable 25 and the back-plate 35 may be determined according to the application. A desirable limit may be determined for the separation of the cable 35 and the back-plate 35 and the movable member may be moved to urge the portion of the cable 25 against the back-plate 35 to ensure that the desirable limit is achieved. In one example, the term "a position against the back-plate" or "against the back-plate", as used above, means that at least a portion of the cable 25 is separated from the back-plate 35, when attached by the fixing, by no more than 5mm, and preferably by no more than 1mm.

So that the motor 45 is not activated unnecessarily, the television 5 is also provided with a camera or other example of a sensor 55 positioned so that at least the portion of the cable 25 that is intended to be attached to the metal back-plate 35 is within the field of view of the camera 55 or within a sensing range of the sensor 55. The camera or other sensor 55 may be linked to a processor (not shown in Figure 1), for example a processor included on the main circuit board 15, programmed or configured to analyse image data or sensor data to identify when a configuration of the cable 25 changes, e.g. because it has moved due to separation from the back-plate 35. If necessary, a source of illumination may be provided, associated with the camera 55 if used to sense the separation of the cable 25 from the back-plate 35. Detection of a movement of the cable 25 triggers the motor 45 to, for example, move the bar 50 or other movable member along the cable 25, urging the cable 25 against the back-plate 35 and so re-attaching or ensuring attachment of the cable 25 to the back-plate 35 by the fixing.

In another example, the sensor 55 may comprise a movement sensor arranged to sense movement of the cable 25, or a displacement sensor arranged to sense a change in position of a portion of the cable 25.

In another example arrangement, the sensor 55 may comprise a receiver tuned to receive electromagnetic signals of one or more frequencies expected for the LVDS cable 25 in the television 5. The sensor 55 may thereby monitor electromagnetic emissions by the cable 25 and detect any increase in those emissions, potentially indicative that the attachment of the cable 25 has failed. Detection of any increase in emissions may be arranged to trigger the motor 45 to re-attach or ensure attachment of the cable 25 to the back-plate 35, or to move the cable 25 to a position against the back-plate 35 and to hold it there.

Examples have been described above in the context of a television 5 using an LVDS cable 25 to communicate image data to a digital display screen circuit 30. However, as would be apparent to a person of ordinary skill in the relevant art, the techniques disclosed herein may be applied to television screens or monitors, computer displays or monitors, and displays for other computing devices, including smartphones, tablet computers, laptop computers, etc. Furthermore, the cable and associated interface may relate to any type of interface or signalling standard for which it is known that the cable may emit electromagnetic radiation and for which it may be beneficial for the cable to remain in a position against a metal structure thereby to reduce those emissions.

Examples disclosed herein may be applied to electronic display devices as may be used in many public environments in so-called "signage", for example, for displaying advertisements or for information or entertainment that is of interest to a larger audience. In general, the display panel or screen may use LCDs (liquid crystal display devices) as the display elements, with for example a backlight which may be an edgelit backlight or a direct-lit backlight, which uses a light source (such as an LED or light emitting diode) for each display cell or element. In other examples, the light sources may effectively generate the pixels directly, i.e. the light from the light source corresponds to the light required for that pixel and no backlight is required. (The light sources may for example generate coloured light or may generate white light which is then passed through controllable coloured filters so as to achieve different colours in the image.) Display devices that generate the pixels directly include for example display devices that use OLEDs (organic light emitting diodes), (inorganic) LEDs, including for example an LED display or "wall" or a micro LED display, and plasma technology. In signage or similar applications, the display device may be located in a position that is not easily accessible for maintenance purposes, such as high above the ground in a public space. Examples disclosed herein are particularly useful in such cases as it allows the display device to maintain the cable in a position against the metal structure effectively autonomously, without requiring physical access by a maintenance engineer.

It will be understood that the processor or processing system or circuitry referred to herein may in practice be provided by a single chip or integrated circuit or plural chips or integrated circuits, optionally provided as a chipset, an application-specific integrated circuit (ASIC), field-programmable gate array (FPGA), digital signal processor (DSP), graphics processing units (GPUs), etc. The chip or chips may comprise circuitry (as well as possibly firmware) for embodying at least one or more of a data processor or processors, a digital signal processor or processors, baseband circuitry and radio frequency circuitry, which are configurable so as to operate in accordance with the exemplary embodiments. In this regard, the exemplary embodiments may be implemented at least in part by computer software stored in (non-transitory) memory and executable by the processor, or by hardware, or by a combination of tangibly stored software and hardware (and tangibly stored firmware).

Although at least some aspects of the embodiments described herein with reference to the drawings comprise computer processes performed in processing systems or processors, the invention also extends to computer programs, particularly computer programs on or in a carrier, adapted for putting the invention into practice. The program may be in the form of non-transitory source code, object code, a code intermediate source and object code such as in partially compiled form, or in any other non-transitory form suitable for use in the implementation of processes according to the invention. The carrier may be any entity or device capable of carrying the program. For example, the carrier may comprise a storage medium, such as a solid-state drive (SSD) or other semiconductor-based RAM; a ROM, for example a CD ROM or a semiconductor ROM; a magnetic recording medium, for example a floppy disk or hard disk; optical memory devices in general; etc.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A method for maintaining a position of a signal-carrying cable (25) against a metal structure (35) to reduce electromagnetic emissions by the cable (25) when in use, the method comprising:
determining that at least a portion of the cable (25) is no longer in said position against the metal structure (35); and,
in response thereto, urging a movable member (50) against at least a portion of the cable (25) thereby to urge the at least a portion of the cable (25) against the metal structure (35).

2. The method according to claim 1, wherein one or both of the cable (25) and the metal structure (35) are provided with a re-attachable fixing for attaching at least a portion of the cable (25) in said position against the metal structure (35), and the urging the movable member (50) against at least a portion of the cable (25) attaches the at least a portion of the cable (25) in said position against the metal structure (35) by the re-attachable fixing.

3. The method according to claim 1 or claim 2, comprising moving the movable member (50) along the at least a portion of the cable (25) while in contact with the at least a portion of the cable (25), thereby to urge the at least a portion of the cable (25) against the metal structure (35).

4. The method according to any of claims 1 to 3, wherein the movable member (50) is mounted to move about a pivot while in contact with the at least a portion of the cable (25) and the method comprises rotating the movable member (50) about the pivot thereby to urge the at least a portion of the cable (25) against the metal structure (35).

5. The method according to any of claims 1 to 4, wherein the movable member (50) is linked to a motor (45) and the method comprises controlling the motor (45) to move the movable member (50) thereby to urge the at least a portion of the cable (25) against the metal structure (35).

6. The method according to claim 5, comprising sensing a change in the configuration of the at least a portion of the cable (25) using a sensor (55), indicative that a repositioning of the at least a portion of the cable (25) is required, and activating the motor (45) to urge the at least a portion of the cable (25) against the metal structure (35).

7. The method according to claim 6, wherein the sensor (55) comprises one or more of a camera, a movement sensor, a displacement sensor and a receiver of electromagnetic signals, arranged to sense a change in the configuration of the at least a portion of the cable (25).

8. The method according to claim 7, wherein the sensor (55) is a receiver of electromagnetic signals, the method comprising, upon detecting an increase in the emission of electromagnetic signals, activating the motor (45) to urge the at least a portion of the cable (25) against the metal structure (35).

9. An electronic device (5) comprising:
a metal structure (35);
a cable (25) for carrying signals, at least a portion of the cable (25) being in a position against the metal structure (35) to reduce electromagnetic emissions by the cable (25) when in use;
a movable member (50); and
a sensor arrangement configured to determine when the at least a portion of the cable (25) is no longer in said position against the metal structure (35),
the arrangement being such that the movable member (50) is urged against at least a portion of the cable (25) in response to the sensor arrangement determining that the at least a portion of the cable (25) is no longer in said position against the metal structure (35).

10. The electronic device (5) according to claim 9, wherein one or both of the at least a portion of the cable (25) and the metal structure (35) are provided with a re-attachable fixing for attaching at least a portion of the cable (25) in said position against the metal structure (35), and the urging the movable member (50) against at least a portion of the cable (25) attaches the at least a portion of the cable (25) in said position against the metal structure (35) by the re-attachable fixing.

11. The electronic device (5) according to claim 9 or claim 10, wherein the movable member (50) is arranged to move along the at least a portion of the cable (25) while in contact with the at least a portion of the cable (25), thereby to urge the at least a portion of the cable (25) against the metal structure (35).

12. The electronic device (5) according to any of claims 9 to 11, wherein the movable member (50) is mounted to move about a pivot while in contact with the at least a portion of the cable (25), thereby to urge the at least a portion of the cable (25) against the metal structure (35).

13. The electronic device (5) according to any of claims 9 to 12, comprising a motor (45) linked to move the movable member (50) thereby to urge the at least a portion of the cable (25) against the metal structure (35).

14. The electronic device (5) according to claim 13, wherein the sensor arrangement comprises a controller linked to a sensor (55) and to the motor (45), the sensor (55) comprising at least one of a camera, a movement sensor, a displacement sensor and a receiver of electromagnetic signals, wherein the controller is configured to receive sensor data from the sensor (55), to detect therefrom a change in the configuration of the at least a portion of the cable (25), indicative that the at least a portion of the cable (25) is no longer in said position against the metal structure (35), and to activate the motor (45) to urge the at least a portion of the cable (25) against the metal structure (35).

15. The electronic device (5) according to claim 14, wherein the sensor (55) is a receiver of electromagnetic signals, the controller being configured, upon detecting an increase in the emission of electromagnetic signals, to activate the motor (45) to urge the at least a portion of the cable (25) against the metal structure (35).
